# EUROPÄISCHE PATENTSCHRIFT

(11) **EP 0 444 234 B1**
(45) Veröffentlichungstag und Bekanntmachung des Hinweises auf die Patenterteilung: **07.06.1995**
(21) Anmeldenummer: 90104107.9
(22) Anmeldetag: 02.03.1990
(51) Int. Cl.: H03M 1/18, H03M 1/06, H03M 1/20

(54) **Verfahren und Einrichtung zur Analog-Digital-Wandlung**
Method and device for analogue/digital conversion
Procédé et dispositif de conversion analogique/numérique

(43) Veröffentlichungstag der Anmeldung: 04.09.1991
(73) Patentinhaber: Siemens-Elema AB, 171 95 Solna 1 (SE); SIEMENS AKTIENGESELLSCHAFT, 80333 München (DE)
(72) Erfinder: Hjorth, Bo, Ing., S-191 43 Sollentuna (SE); Ohlsson, Thomas, Dipl.-Ing., S-162-43 Vällingby (SE)

(56) Entgegenhaltungen:
- US-A- 4 851 842

## Beschreibung

Die Erfindung betrifft ein Verfahren und eine Vorrichtung zur Analog/Digital-Wandlung eines sich zeitlich ändernden analogen elektrischen Eingangssignals.

Es sind derzeit als integrierte Schaltungen ausgeführte Analog/ Digital-Wandler verfügbar, die z.B. nach dem sogenannten "Dual Slope"-Verfahren arbeiten und die Analog/Digital-Wandlung eines sich zeitlich ändernden analogen elektrischen Eingangssignals mit einer Auflösung von bis zu 16 bit gestatten. Sollen derartige Analog/Digital-Wandler, wie dies z.B. im Falle der Elektrokardiographie (EKG) oder der Elektroencephalographie (EEG) erforderlich ist, derart betrieben werden, daß der kleinste erfaßbare Spannungsunterschied des zu messenden Signals, der einem least significant bit (LSB) der Analog/Digital-Wandlung entspricht, in der Größenordnung von einigen Mikrovolt liegt, ergibt sich nur ein sehr eingeschränkter Dynamikbereich für das zu messende Signal, was zur Folge hat, daß der Analog/Digital-Wandler sehr rasch durch das zu messende Signal übersteuert wird. Dies ist im Falle der Elektrokardiographie, wo auch unmittelbar nach einer Defibrillation, dabei wird das Herz eines Patienten mit Impulsen relativ hoher Spannung und Stromstärke beaufschlagt, die Aufzeichnung eines Elektroardiogramms möglich sein soll, in höchstem Maße unerwünscht. Eine denkbare Abhilfe wäre hier die Verwendung von Analog/Digital-Wandlern mit höherer Auflösung (bit-Anzahl). Während jedoch bereits die Verwendung eines als integrierte Schaltung ausgeführten Analog/Digital-Wandlers der erwähnten Auflösung mit erheblichen Kosten verbunden ist, würde dies die Verwendung eines diskret aufgebauten Analog/Digital-Wandlers erfordern, was einen ganz beträchtlichen technischen und finanziellen Aufwand nach sich ziehen würde. Dieser Aufwand kann wenigstens zum Teil vermieden werden, wenn von dem sogenannten DAC-Feed Sack-Verfahren Gebrauch gemacht wird. Dabei wird anhand der einer elektronischen Recheneinrichtung zugeführten digitalen Ausgangssignale des verwendeten Analog/Digital-Wandlers ein mit der elektronischen Recheneinrichtung verbundener Digital/Analog-Wandler von der elektronischen Recheneinrichtung derart angesteuert, daß er ein analoges Ausgangssignal erzeugt, das mittels eines Differenzverstärkers von dem zu messenden Signal subtrahiert wird. Dabei wird der Digital/Analog-Wandler mittels der elektronischen Recheneinrichtung in Abhängigkeit von der momentanen Amplitude des zu messenden Signals jeweils derart angesteuert, daß das Ausgangssignal des Differenzverstärkers, das dem Analog/Digital-Wandler zugeführt ist, dessen Dynamikbereich nicht überschreitet. Die dem Ausgangssignal des Differenzverstärkers entsprechenden digitalen Daten werden anschließend korrigiert, indem die elektronische Recheneinrichtung zu diesen den jeweils entsprechenden Wert des Ausgangssignals des Digital/Analog-Wandlers addiert. Exakte Ergebnisse werden mit diesem Verfahren jedoch nur dann erhalten, wenn die Auflösung (bit-Anzahl) des Digital/Analog-Wandlers der angestrebten Auflösung der Analog/Digital-Wandlung entspricht. Da jedoch bei Digital/Analog-Wandlern ähnliche Probleme auftreten, wie sie bereits im Zusammenhang mit Analog/Digital-Wandlern beschrieben wurden, finden in der Regel Digital-Analog-Wandler Verwendung, deren Auflösung geringer als die angestrebte Auflösung der Analog/Digital-Wandlung ist. Dies führt zu Ungenauigkeiten. So enthalten die Ergebnisse der Analog/Digital-Wandlung z.B. Sprünge, die in dem analogen Eingangssignal in dieser Weise nicht vorhanden sind. Ein weiterer Nachteil des beschriebenen Verfahrens liegt in der Notwendigkeit eines zusätzlichen Digital/Analog-Wandlers, der zusätzliche Kosten verursacht.

Der Erfindung liegt die Aufgabe zugrunde, ein Verfahren und eine Einrichtung zur Analog/Digital-Wandlung eines sich zeitlich ändernden analogen elektrischen Eingangssignals anzugeben, die technisch einfach und kostengünstig sind, einen großen Dynamikumfang aufweisen und gleichzeitig die Messung sehr kleiner Spannungsänderungen gestatten, und insbesondere zur Analog/Digital-Wandlung elektrokardiographischer Signale geeignet sind.

Der das Verfahren betreffende Teil der Aufgabe wird gemäß der Erfindung durch das Verfahren nach dem Patentanspruch 1 gelöst. Demnach werden die Ergebnisse der Analog/Digital-Wandlung unter Heranziehung sowohl der dem aus dem Eingangssignal durch Anwendung einer ersten Übertragungsfunktion und Verstärkung um einen definierten Verstärkungsfaktor gewonnenen aufbereiteten Signal entsprechenden digitalen Daten als auch der unter Anwendung einer zweiten Übertragungsfunktion digital gefilterten und mit einem dem definierten Verstärkungsfaktor entsprechenden definierten Faktor multiplizierten, dem Eingangssignal entsprechenden digitalen Daten ermittelt. Dabei entspricht bei der Analog/Digital-Wandlung des aufbereiteten Signals infolge der bei der Aufbereitung des Eingangssignals unter anderem vorgenommenen Verstärkung mit dem definierten Verstärkungsfaktor eine Änderung des Resultats der Analog/Digital-Wandlung um ein LSB einer Spannungsänderung des Eingangssignals, die sich aus der Division des einem LSB entsprechenden Spannungsunterschiedes durch den definierten Verstärkungsfaktor ergibt. Weiter erfolgt infolge des Umstandes, daß auf die mit dem definierten Faktor multiplizierten, dem Eingangssignal entsprechenden digitalen Daten die zweite Übertragungsfunktion durch digitales Filtern angewendet wird, in diesem Zusammenhang wird bezüglich weiterer Informationen auf das Buch "Theory and Application of Digital Signal Processing" von L.R. Rabiner und B. Gold, Prentice-Hall, Inc., New Jersey, ISBN 0-13-914 101-4, sozusagen eine "Interpolation" zwischen durch ein LSB voneinander getrennten dem Eingangssignal entsprechenden Daten hingewiesen. Wenn man dann die Ergebnisse der Analog/Digital-Wandlung unter Heranziehung sowohl der dem aufbereiteten Signal als auch der der digital gefilterten Eingangssignal entsprechenden digitalen Daten ermittelt, erhält man als Summe digitale Daten, deren bit-Anzahl infolge der beschriebenen Maßnahmen höher als die bit-Anzahl der Analog/Digital-Wandlung ist, und zwar zweckmäßigerweise um ein Maß, das dem definierten Verstärkungsfaktor ergibt. Es ergibt sich dann z.B. im Falle eines definierten Verstärkungsfaktors von 32 eine Erhöhung der bit-Anzahl um fünf bit, während ein definierter Verstärkungsfaktor von 16 eine Erhöhung von nur vier bit ergeben würde. Unter der Voraussetzung, daß der Dynamikumfang des aufbereiteten Signals im wesentlichen um einen wenigstens dem definierten Verstärkungsfaktor entsprechenden Faktor geringer als der Dynamikumfang des Eingangssignals ist, was die Voraussetzung dafür ist, daß bezüglich des aufbereiteten Signals Überschreitungen des Dynamikbereiches der Analog/Digital-Wandlung ausgeschlossen sind, gestattet es das erfindungsgemäße Verfahren also, das Eingangssignal auf technisch einfache und kostengünstige Weise einer Analog/Digital-Wandlung zu unterziehen, die einen großen Dynamikumfang aufweist und gleichzeitig die Messung sehr kleiner Spannungsänderungen gestattet.

Eine insbesondere für die Elektrokardiographie vorteilhafte Variante der Erfindung ist in dem Patentanspruch 2 angegeben. Infolge des Umstandes, daß als erste Übertragungsfunktion die eines Hochpasses angewendet wird, ist nämlich gewährleistet, daß das aufbereitete Signal auch nach einer Defibrillation den diagnostisch wesentlichen dynamischen Anteil des Eingangssignals korrekt wiedergibt, ohne daß Überschreitungen des Dynamikbereiches auftreten, da diejenigen Signalanteile des Eingangssignals ausgefiltert sind, die der durch die Defibrillation bewirkten Gewebepolarisation entsprechen.

Eine besonders vorteilhafte Variante der Erfindung ist in dem Patentanspruch 3 angegeben. Infolge des Umstandes, daß auf die mit dem definierten Faktor multiplizierten, dem Eingangssignal entsprechenden digitalen Daten durch digitales Filtern das komplexe Komplement der ersten Übertragungsfunktion angewendet wird und die so erhaltenen digitalen Daten zu den dem aufbereiteten Signal entsprechenden digitalen Daten addiert werden, werden den dem aufbereiteten Signal entsprechenden digitalen Daten diejenigen Signalanteile wieder hinzugefügt, die durch die Anwendung der ersten Übertragungsfunktion entfernt wurden. Es ist also gewährleistet, daß die Ergebnisse der Analog/Digital-Wandlung sämtliche Signalanteile des Eingangssignales berücksichtigen.

Sollten bei der Analog/Digital-Wandlung des aufbereiteten Signals Überschreitungen des Dynamikbereiches auftreten, wird von einer besonders vorteilhaften Ausführungsform der Erfindung Gebrauch gemacht, die im Patentanspruch 6 angegeben ist. In diesem Falle erhält man ohne Berücksichtigung der dem aufbereiteten Signal entsprechenden digitalen Daten als Ergebnis der Analog/Digital-Wandlung digitale Daten, deren bit-Anzahl höher als die bit-Anzahl der Analog/Digital-Wandlung ist. Dies hat seinen Grund wieder darin, daß bei der durch digitales Filtern erfolgenden Anwendung der integrierenden Übertragungsfunktion zwischen um 1 LSB voneinander getrennten, dem Eingangssignal entsprechenden, mit dem definierten Faktor multiplizierten digitalen Daten eine "Interpolation" erfolgt. Vorzugsweise wird die Zeitkonstante der Integration derart gewählt, daß die Integration jeweils eine Anzahl von digitalen Daten umfaßt, die dem definierten Verstärkungsfaktor entspricht. Diejenigen digitalen Daten, die dann als dem Eingangssignal entsprechende digitale Daten verwendet werden, besitzen dann bei einem Verstärkungsfaktor von beispielsweise 32 eine bit-Anzahl, die um 5 bit höher als die bit-Anzahl der Analog/ Digital-Wandlung ist. Bei dem analogen elektrischen Signal kann es sich beispielsweise um ein periodisches Signal, z.B. ein Sägezahnsignal, oder ein nicht periodisches Signal, z.B. Rauschen, handeln. Wesentlich ist nur, daß das Signal eine statistisch gleichmäßige Amplitudenverteilung besitzt. Da das Verfahren gemäß Patentanspruch 6 insbesondere auch hinsichtlich des dynamischen Anteils des Eingangssignals mit einer im Vergleich zu den Verfahren nach den Patentansprüchen 1 bis 5 etwas geringeren Genauigkeit arbeitet, sollte von dem Verfahren nach Patentanspruch 6 nur dann Gebrauch gemacht werden, wenn dies tatsächlich erforderlich ist.

Der die Einrichtung betreffende Teil der Aufgabe wird durch die im Patentanspruch 9 angegebene Einrichtung gelöst, deren Wirkungsweise und Vorteile sich aus der vorangegangenen Beschreibung des erfindungsgemäßen Verfahrens ergeben.

Das im Patentanspruch 23 angegebene Verfahren zur Eichung einer erfindungsgemäßen Einrichtung liefert als Ergebnisse des Vergleiches digitale Daten, die es gestatten, den definierten Verstärkungsfaktor und den definierten Faktor einander genau anzugleichen sowie gegebenenfalls eine Abstimmung der zweiten Übertragungsfunktion auf die erste Übertragungsfunktion in dem Sinne vorzunehmen, daß die zweite Übertragungsfunktion tatsächlich das komplexe Komplement der ersten Übertragungsfunktion darstellt.

Weitere Vorteile der Erfindung ergeben sich anhand der Beschreibung eines in den beigefügten Figuren dargestellten Ausführungsbeispieles. Es zeigen:
- Fig. 1: in schematischer Darstellung ein Blockschaltbild einer erfindungsgemäßen Einrichtung zur Analog/Digital-Wandlung,
- Fig. 2 und 3: Analog-Schaltungen zur Veranschaulichung unterschiedlicher Betriebsweisen der Einrichtung gemäß Fig. 1, und
- Fig. 4: ein Diagramm zur Veranschaulichung einer weiteren Betriebsart des erfindungsgemäßen Gerätes.

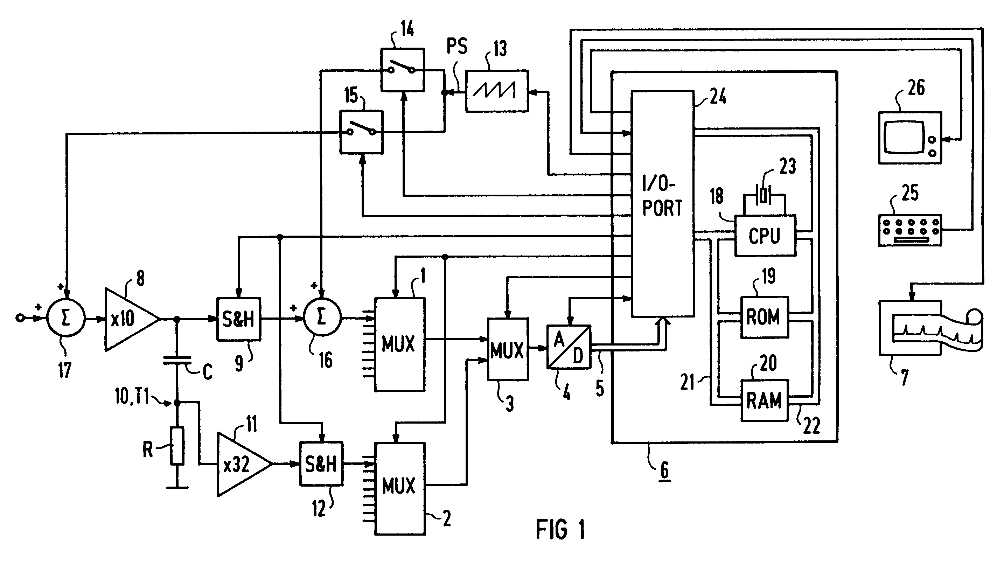

In der Fig. 1 ist eine erfindungsgemäße Einrichtung dargestellt, die Bestandteil einer Einrichtung zur Verarbeitung und Aufzeichnung von elektrokardiographischen Signalen ist. Dabei ist ein erster 9:1-Kanal Analog-Multiplexer 1 vorgesehen. Jedem von dessen Eingängen ist eine der üblicherweise 9 (3 Extremitäten- und 7 Brustableitungen) EKG-Ableitungen zugeordnet. Parallel zu dem ersten Multiplexer 1 liegt ein zweiter Multiplexer 2, der ebenfalls als 9:1-Kanal Analog-Multiplexer ausgeführt ist und dessen Zweck im weiteren deutlich werden wird. Die Ausgänge der beiden Multiplexer 1 und 2 sind mit den Eingängen eines 2:1-Kanals Analog-Multiplexers 3 verbunden, dessen Ausgangssignal dem Eingang eines Analog/Digital-Wandlers 4 zugeführt ist, bei dem es sich um einen 14-bit-Wandler handelt. Die digitalen Ausgangsdaten des Analog/Digital-Wandlers 4 gelangen über einen Datenbus 5 zu einer elektronischen Recheneinrichtung 6, in der sie weiterverarbeitet werden. An die elektronische Recheneinrichtung 6 ist ein Aufzeichnungsgerät 7 angeschlossen, bei dem es sich, wie in der Fig. 1 schematisch angedeutet ist, um einen mittels der elektronischen Recheneinrichtung 6 ansteuerbaren EKG-Schreiber handelt.

Die den einzelnen EKG-Ableitungen entsprechenden Signale gelangen nicht unmittelbar zu dem ihnen jeweils zugeordneten Eingang des ersten Multiplexers 1. Sie durchlaufen vielmehr, wie dies in der Fig. 1 am Beispiel eines Kanals dargestellt ist, einen Verstärker 8, der im Falle des dargestellten Ausführungsbeispieles einen Verstärkungsfaktor von 10 aufweist. Das Ausgangssignal des Verstärkers 8 ist einer Sample and Hold-Schaltung 9 zugeführt, deren Ausgang mit einem Eingang des ersten Multiplexers 1 verbunden ist. Das Ausgangssignal des Verstärkers 8 ist außerdem einem durch einen Kondensator C und einen Widerstand R gebildeten, mit 10 bezeichneten Hochpaß erster Ordnung zugeführt, der dazu dient, auf das ihm zugeführte Signal eine erste Übertragungsfunktion T1 anzuwenden, bei der es sich selbstverständlich um die des Hochpasses 10 selbst handelt. Die Grenzfrequenz des Hochpasses 10 ist ausreichend niedrig gewählt, um die Unterdrückung von diagnostisch relevanten tieffrequenten Anteilen des Eingangssignals zu vermeiden. Das Ausgangssignal des Hochpasses 10 gelangt zu einem zweiten Verstärker 11, der dieses mit einem definierten Verstärkungsfaktor V, im Falle des dargestellten Ausführungsbeispiels V = 32, verstärkt. Das Ausgangssignal des zweiten Verstärkers 11 ist einer zweiten Sample and Hold-Schaltung 12 zugeführt, deren Ausgang mit einem der Eingänge des zweiten Multiplexers 2 verbunden ist, und zwar mit demjenigen Eingang, der dem mit der zu dem jeweiligen Kanal gehörigen ersten Sample and Hold-Schaltung 9 verbundenen Eingang des ersten Multiplexers 1 entspricht. Im Falle des dargestellten Ausführungsbeispieles sind die Sample and Hold-Schaltungen 9 und 12 jeweils mit dem zweiten Eingang (von oben gezählt) des Multiplexers 1 bzw. 2 verbunden. Die Sample and Hold-Schaltungen 9 und 12 können auch entfallen, falls sichergestellt ist, daß die Folgefrequenz der Analog/Digital-Wandlungen für jeden Kanal der Einrichtung deutlich oberhalb der höchsten interessierenden Signalfrequenz bzw. der oberen Grenzfrequenz des zugeführten Signals liegt.

Im folgenden wird das der ersten Sample and Hold-Schaltung 9 zugeführte Signal ungeachtet dessen, daß es zuvor mittels des Verstärkers 8 verstärkt wird, als Eingangssignal ES bezeichnet, während das aus dem Eingangssignal ES durch Entfernung von dessen Gleichspannungsanteilen mittels des Hochpasses 10 und durch Verstärkung um den definierten Verstärkungsfaktor V mittels des Verstärkers 11 gewonnene und der zweiten Sample and Hold-Schaltung 12 zugeführte Signal als aufbereitetes Signal AS bezeichnet wird.

Sowohl die Multiplexer 1, 2 und 3 als auch die Sample and Hold-Schaltungen 9 und 12 sind über Steuerleitungen mit der elektronischen Recheneinrichtung 6 verbunden, von der sie ihre Steuersignale erhalten. Dabei erfolgt die Ansteuerung der beiden Multiplexer 1 und 2 über eine gemeinsame Steuerleitung derart, daß jeweils die einzelnen Eingänge periodisch aufeinanderfolgend mit dem Ausgang verbunden werden, wobei sich dieser Vorgang zyklisch wiederholt. Während desjenigen Zeitintervalls, für das die zu einer bestimmten EKG-Ableitung gehörigen Eingänge der Multiplexer 1 und 2 mit deren jeweiligem Ausgang verbunden sind, führt die elektronische Recheneinrichtung 6 der jeweiligen Sample and Hold-Schaltung 9 bzw. 12 über die gemeinsame Steuerleitung ein Sperrsignal zu, durch das gewährleistet ist, daß sich die an den jeweiligen Eingängen der Multiplexer 1 und 2 anliegende Spannung während des genannten Zeitintervalls nicht ändert. Den Multiplexer 3 steuert die elektronische Recheneinrichtung 6 derart, daß dieser für die eine Hälfte des genannten Zeitintervalls den Ausgang des Multiplexers 1 und für die andere Hälfte des genannten Zeitintervalls den Ausgang des Multiplexers 2 mit dem Eingang des Analog/Digital-Wandlers 4 verbindet. Dabei ist das genannte Zeitintervall ausreichend lang gewählt, um den Analog/Digital-Wandler 4 während der Hälften dieses Zeitintervalls jeweils die Vornahme einer Analog/Digital-Wandlung zu ermöglichen. Der Analog/Digital-Wandler 4 ist über eine Leitung mit der elektronischen Recheneinrichtung 6 verbunden, über die diese dem Analog/Digital-Wandler 4 jeweils zum geeigneten Zeitpunkt einen Impuls zuführt, der den Beginn einer Analog/Digital-Wandlung einleitet. Umgekehrt gibt der Analog/Digital-Wandler 4 über die gleiche Leitung ein Signal an die elektronische Recheneinrichtung 6 ab, wenn er eine Analog/Digital-Wandlung abgeschlossen hat. Dabei gibt die elektronische Recheneinrichtung 6 im Falle des beschriebenen Ausführungsbeispieles die eine Analog/Digital-Wandlung einleitenden Impulse mit einer derartigen Folgefrequenz ab, daß Aliasing-Effekte vermieden sind. Es wird also deutlich, daß der Analog/Digital-Wandler 4 der elektronischen Recheneinrichtung 6 einen Strom digitaler Daten zuführt, der bei der abwechselnden, quasi-gleichzeitigen Analog/Digital-Wandlung des Eingangssignals ES bzw. des aufbereiteten Signals AS der den einzelnen Kanälen entsprechenden EK-Ableitungen erhalten wird, wobei die digitalen Daten jeweils die gleiche bit-Anzahl von 14 bit aufweisen.

Gemäß Fig. 1 ist außerdem ein Signalgenerator 13 vorhanden, der ein periodisches Signal PS mit einer statistisch gleichmäßigen Amplitudenverteilung, z.B. ein Sägezahnsignal, erzeugt. Das mittels des Signalgenerators 13 erzeugte periodische Signal PS ist über zwei elektronische Schalter 14, 15, die über entsprechende Steuerleitungen durch die elektronische Recheneinrichtung 6 betätigbar sind, Summierungspunkten 16 bzw. 17 zuführbar, die zwischen der Sample and Hold-Schaltung 9 und dem Multiplexer 1 bzw. vor dem Eingang des Verstärkers 8 liegen. Es besteht also die Möglichkeit, das mittels des Signalgenerators 13 erzeugte periodische Signal PS wahlweise den Samples des Eingangssignals ES oder dem dem Verstärker 8 zugeführten Signal zu überlagern. Die Frequenz des periodischen Signals PS ist vorzugsweise derart gewählt, daß seine Periodendauer derjenigen Zeit entspricht, die für eine dem definierten Verstärkungsfaktor V entsprechende Anzahl von Analog/Digital-Wandlungen jeweils zusammengehöriger Samples des Eingangssignals ES und des Ausgangssignals AS erforderlich ist. Um die erforderliche Synchronisation zu erreichen, ist der Signalgenerator 13 über eine Steuerleitung mit der elektronischen Recheneinrichtung 6 verbunden.

Die elektronische Recheneinrichtung 6 ist in an sich bekannter Weise aus einer Zentraleinheit (CPU) 18, einem Nur-Lese-Speicher (ROM) 19 und einem Schreib-Lese-Speicher (RAM) 20 aufgebaut, die über einen Adressbus 21 und einen Datenbus 22 miteinander verbunden sind. Das ROM 19 und das RAM 20 dienen zur Speicherung des Betriebssystems, des eigentlichen Programms sowie variabler Daten. An die CPU 18 ist ein Quarz 23 angeschlossen, der zur Erzeugung der zum Betrieb der elektronischen Recheneinrichtung 6 erforderlichen Taktsignale dient, aus denen auch die Steuersignale für die Multiplexer 1 bis 3, den Analog/Digital-Wandler 4, die Sample and Hold-Schaltungen 9 und 12 und den Signalgenerator 13 abgeleitet werden. Diese Signale gelangen über einen Eingangs-/Ausgangs-Schaltkreis (I/O-PORT) 24, der sowohl an den Adressbus 21 als auch an den Datenbus 22 angeschlossen ist, zu den genannten Komponenten. Auch der Datenbus 5, über den die digitalen Ausgangssignale des Analog/Digital-Wandlers 4 zu der elektronischen Recheneinrichtung 6 gelangen, ist an den I/O-PORT 24 angeschlossen. Weiter sind an diesen eine Tastatur 25, ein Datensichtgerät 26 und das bereits erwähnte Aufzeichnungsgerät 7 angeschlossen.

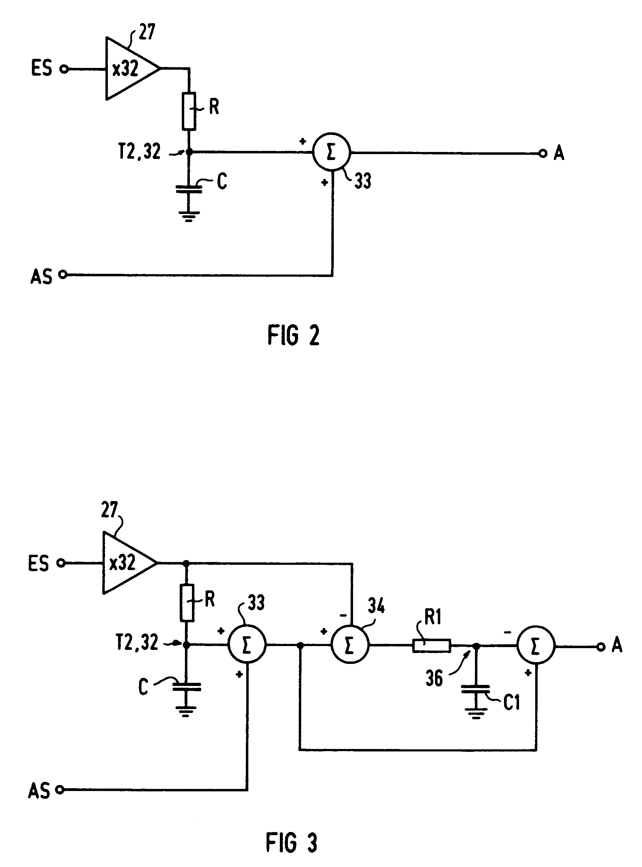

Mittels der elektronischen Recheneinrichtung 6 werden die den Eingangssignalen ES und den aufbereiteten Signalen AS entsprechenden digitalen Daten in einer solchen Weise verarbeitet, daß einerseits Eingangssignale ES unter voller Ausnutzung des Dynamikbereiches des Analog/Digital-Wandler 4 gewandelt werden können und andererseits Spannungsänderungen des Eingangssignals ES kleiner sind als diejenige Spannungsänderung, die bei direkter Zufuhr des Eingangssignals ES zu dem Eingang des Analog/Digital-Wandlers 4 und ohne anschließende Verarbeitung der digitalen Ausgangsdaten des Analog/Digital-Wandlers 4 eine Änderung des Resultates der Analog/Digital-Wandlung um ein LSB bewirken würde. Dies wird im folgenden anhand eines Kanals der Einrichtung gemäß Fig. 1 erläutert, wobei auf in den Fig. 2 und 3 dargestellter Analog-Schaltungen Bezug genommen wird, die dazu dienen, das von der elektronischen Recheneinrichtung 6 ausgeführte Programm, soweit es um die Verarbeitung der der elektronischen Recheneinrichtung 6 von dem Analog/Digital-Wandler 4 zugeführten Daten geht, zu verdeutlichen. Es wird darauf hingewiesen, daß die Fig. 2 und 3 nur erklärenden Charakter haben und keinesfalls dahingehend mißverstanden werden dürfen, daß anstelle der als Digitalrechner ausgebildeten elektronischen Recheneinrichtung 6 auch ein Analogrechner Verwendung finden kann. Dies ist schon wegen der der elektronischen Recheneinrichtung 6 von dem Analog/Digital-Wandler 4 zugeführten digitalen Daten ausgeschlossen, die mittels eines Analogrechners nicht verarbeitet werden könnten.

Die dem Eingangssignal ES entsprechenden, von dem Analog/Digital-Wandler 4 gelieferten digitalen Daten, die durch die Analog/Digital-Wandlung des jeweiligen Ausgangssignals der Sample and Hold-Schaltung 9 erhalten werden, multipliziert die elektronische Recheneinrichtung 6 grundsätzlich jeweils mit einem definierten Faktor F, der dem definierten Verstärkungsfaktor V entspricht, mit dem das Ausgangssignal des Hochpasses 10 zur Gewinnung des aufbereiteten Signals AS verstärkt wird. Der definierte Faktor F beträgt im Falle des beschriebenen Ausführungsbeispieles demzufolge F = 32. Dies ist in Fig. 2 durch einen Verstärker 27 mit entsprechendem Verstärkungsfaktor angedeutet.

In der bevorzugten Betriebsart der erfindungsgemäßen Einrichtung wendet die elektronische Recheneinrichtung 6 auf die dem Eingangssignal ES entsprechenden, mit dem definierten Faktor F multiplizierten digitalen Daten durch digitales Filtern eine zweite Übertragungsfunktion T2 an. Bei der zweiten Übertragungsfunktion T2 handelt es sich um das komplexe Komplement der ersten Übertragungsfunktion T1, mit der das Eingangssignal ES zur Bildung des aufbereiteten Signals AS von Gleichspannungsanteilen befreit wird. Die durch das digitale Filtern erhaltenen digitalen Daten addiert die elektronische Recheneinrichtung 6 in zeitlich korrekter Beziehung zu den durch die Digital/Analog-Wandlung des aufbereiteten Signals AS erhaltenen digitalen Daten. Das Resultat dieser Addition stellt das Ergebnis der Analog/Digital-Wandlung dar und wird von der elektronischen Recheneinrichtung als solches berücksichtigt.

Bekanntermaßen haben eine mathematische Funktion und das zu ihr gehörige komplexe Komplement die Eigenschaft, daß, wenn man sie jeweils mit einer dritten mathematischen Funktion multipliziert, die Summe der so erhaltenen Produkte der dritten mathematischen Funktion entspricht. Im vorliegenden Fall bedeutet dies, daß dem aufbereiteten Signal AS durch die beschriebene Addition diejenigen Signalanteile wieder hinzugefügt werden, die beim Durchlaufen des Hochpasses 10 verloren gehen. Dies hat zur Folge, daß die in dem Eingangssignal ES enthaltenen Gleichspannungsanteile berücksichtigt sind. Da bei der digitalen Filterung eine "Interpolation" auch zwischen solchen dem Eingangssignal ES entsprechenden digitalen Daten stattfindet, die um ein LSB voneinander getrennt sind, wird der Vorteil erzielt, daß diejenigen digitalen Daten, die durch die beschriebene Addition zustande kommen, bei ausreichender Genauigkeit der im Zusammenhang mit der digitalen Filterung vorgenommenen Rechenvorgänge eine bit-Anzahl aufweisen, die größer als die bit-Anzahl des Analog/Digital-Wandlers 4 ist. Im Falle des beschriebenen Ausführungsbeispieles, wo der definierte Verstärkungsfaktor V und der definierte Faktor F jeweils 32 betragen, führt die elektronische Recheneinrichtung 6 die zur digitalen Filterung erforderlichen Rechenvorgänge mit einer solchen Genauigkeit aus, daß sich eine Erhöhung der bit-Anzahl z = 14 der Analog/Digital-Wandlung um 5 bit auf insgesamt 19 bit ergibt.

Im Falle des beschriebenen Ausführungsbeispieles durchläuft das Eingangssignal ES zur Bildung des aufbereiteten Signals AS einen Hochpaß erster Ordnung 10. Bei dem dessen Übertragungsfunktion T1 entsprechenden komplexen Komplement handelt es sich um die Übertragungsfunktion T2 eines Tiefpasses erster Ordnung, dessen Grenzfrequenz gleich der Grenzfrequenz des Hochpasses 10 ist. Es wird darauf hingewiesen, daß dies nicht in entsprechender Weise gilt, wenn anstelle des Hochpasses erster Ordnung 10 ein Hochpaß höherer Ordnung verwendet wird. In diesem Falle müssen der Übertragungsfunktion des entsprechenden Tiefpasses Korrekturglieder zugefügt werden, um das komplexe Komplement zu erhalten. Im übrigen muß es sich bei der Übertragungsfunktion T1 nicht zwangsläufig um die eines Hochpasses handeln. Unter bestimmten Umständen kann es sich bei der Übertragungsfunktion T1 auch um die eines Tief- oder Bandpasses handeln. Auch in diesem Fall muß die Übertragungsfunktion T2 das komplexe Komplement zur Übertragungsfunktion T1, also die Übertragungsfunktion eines Hochpasses bzw. eines Kerbfilters, darstellen.

Die beschriebene Betriebsweise ist in der Fig. 2 dadurch verdeutlicht, daß mit dem Ausgang des Verstärkers 27 ein aus dem Widerstand R und dem Kondensator C gebildeter Tiefpaß erster Ordnung 32, die Werte des Widerstandes R und des Kondensators C entsprechen denen im Falle des Hochpasses 10, verbunden ist, dessen Ausgangssignal an dem Summationspunkt 33 rückwirkungsfrei zu dem aufbereiteten Signal AS addiert wird. Hinter dem Summationspunkt 33 steht also ein Signal zur Verfügung, das infolge des Umstandes, daß zu dem aufbereiteten Signal AS wieder diejenigen Signalanteile addiert werden, die zuvor mittels des Hochpasses 10 entfernt wurden, dem 32fach verstärkten Eingangssignal ES entspricht. Es wird somit deutlich, daß die durch Summation der dem aufbereiteten Signal AS entsprechenden digitalen Daten und derjenigen digitalen Daten, die durch die Anwendung der zweiten Übertragungsfunktion T2 auf die mit dem definierten Faktor F multiplizierten, dem Eingangssignal ES entsprechenden digitalen Daten erhalten werden, gewonnenen Resultate der Analog/Digital-Wandlung eine vorzugsweise dem definierten Verstärkungsfaktor V bzw. dem definierten Faktor F entsprechende erhöhte Auflösung bieten und dennoch die im Eingangssignal ES enthaltenen Gleichspannungsanteile korrekt enthalten.

Die Wirkungsweise der Einrichtung bzw. des Verfahrens wird an einem Zahlenbeispiel nochmals deutlicher werden. Soll mittels des 14-bit-Analog/Digital-Wandlers 4 beispielsweise ein Signal mit einem Dynamikumfang von ± 320 mV mit einer Auflösung von ca. 1,25 »V gemessen werden, so ist dies ohne weiteres offensichtlich nicht möglich, da der kleinste mittels des Analog/Digital-Wandlers meßbare Spannungsunterschied etwa 40 »V beträgt. Da im Falle der Erfindung bei der Bildung des aufbereiteten Signals AS der dynamische Anteil des Eingangssignals ES um den definierten Verstärkungsfaktor V = 32 verstärkt wird, sind hier bezüglich des dynamischen Anteils bzw. des aufbereiteten Signals AS Spannungsunterschiede von 40 »V/32 = 1,25 »V meßbar. Wird weiterhin bei der Anwendung der zweiten Übertragungsfunktion T2 auf die dem Eingangssignal ES entsprechenden, mit dem definierten Faktor F = V = 32 mutliplizierten digitalen Daten durch digitales Filtern derart vorgegangen, daß die zur digitalen Filterung erforderlichen Rechenvorgänge mit einer solchen Genauigkeit ausgeführt werden, daß sich eine Erhöhung bit-Anzahl der Analog/Digital-Wandlung um 5 bit auf insgesamt z = 19 bit ergibt. In diesem Falle beträgt der bei der Analog/Digital-Wandlung des Eingangssignals ES meßbare kleinste Spannungsunterschied ebenfalls etwa 1,25 »V. Es wird also deutlich, daß die durch die beschriebene Addition erhaltenen Ergebnisse der Analog/Digital-Wandlung eine Auflösung von 19 bit aufweisen, wobei der bei dieser Auflösung meßbare kleinste Spannungsunterschied 1,25 »V beträgt.

Geringfügige Ungenauigkeiten können daraus resultieren, daß dem aufbereiteten Signal AS eine durch den Verstärker 11 verursachte Offset-Spannung überlagert ist, die die Ergebnisse der Analog/Digital-Wandlung verfälscht. Diese Ungenauigkeiten können in einer zweiten Betriebsweise der erfindungsgemäßen Einrichtung vermieden werden. In dieser Betriebsweise ermittelt die elektronische Recheneinrichtung 6 für zusammengehörige Samples des Eingangssignals ES und des aufbereiteten Signals AS vorzeichenrichtig jeweils die Differenz zwischen den dem Eingangssignal ES entsprechenden, mit dem definierten Faktor F multiplizierten digitalen Daten einerseits und den durch die Addition der dem aufbereiteten Signal AS entsprechenden digitalen Daten und der durch Anwendung der zweiten Übertragungsfunktion T2 auf die dem Eingangssignal ES entsprechenden, mit dem definierten Faktor F multiplizierten digitalen Daten erhaltenen Summen andererseits. Außerdem bildet die elektronische Recheneinrichtung aus den für eine definierte Anzahl, z.B. 256, aufeinanderfolgender Samples ermittelten Differenzen unter Berücksichtigung von deren Vorzeichen den Mittelwert. Diesen subtrahiert die elektronische Recheneinrichtung 6 von den der bei der Ermittlung des Mittelwertes jeweils zuletzt berücksichtigten Summe entsprechenden digitalen Daten. Es wird also deutlich, daß die oben erwähnten, durch die Offset-Spannung des Verstärkers 11 verursachten Ungenauigkeiten vermieden sind. Die beschriebene Mittelwertbildung ist nicht unbedingt erforderlich und kann daher auch entfallen.

In der Fig. 3, die ansonsten der Fig. 2 entspricht, ist die beschriebene Korrektur der Offset-Spannung des Verstärkers 11 dadurch veranschaulicht, daß an einem Summationspunkt 34 das verstärkte Eingangssignal ES von dem Ausgangssignal des Summierers 33 rückwirkungsfrei subtrahiert wird. Das der Offset-Spannung des Verstärkers 11 entsprechende Signal gelangt von dem Summationspunkte 34 zu einem integrierend wirkenden, aus einem Widerstand R1 und einem gegen Masse geschalteten Kondensator C1 gebildeten RC-Glied 36, mittels dessen eine Mittelwertbildung erfolgt. Der in dem Kondensator C1 gespeicherte Mittelwert wird an einem Summationspunkt 35 rückwirkungsfrei von dem Ausgangssignal des Summierers 33 subtrahiert.

In einer weiteren Betriebsart der erfindungsgemäßen Einrichtung wird von dem Signalgenerator 13 Gebrauch gemacht, der wie erwähnt ein Sägezahnsignal PS erzeugt. Bei dieser Betriebsart schließt die elektronische Recheneinrichtung durch ein entsprechendes Signal den elektronischen Schalter 14, so daß das Sägezahnsignal PS am Summationspunkt 16 dem Eingangssignal ES überlagert wird. Die Maximalamplitude des Sägezahnsignals PS ist wenigstens gleich demjenigen Spannungsunterschied, der eine Änderung der Ausgangsdaten des Analog/Digital-Wandlers 4 um ein LSB bewirkt. Die Periodendauer des Sägezahnsignals PS ist derart gewählt, daß während des Verlaufes des Sägezahnsignals PS entlang seiner linearen Flanke S von dem einen zu dem anderen Extremwert seiner Amplitude mittels des Analog/Digital-Wandlers 4 eine definierte Anzahl von Analog/Digital-Wandlungen vorgenommen wird. Die definierte Anzahl von Analog/Digital-Wandlungen ist vorzugsweise gleich dem definierten Verstärkungsfaktor V. Sie beträgt im Falle des beschriebenen Ausführungsbeispieles also 32.

Infolge des Umstandes, daß an dem Summationspunkt 16 eine Überlagerung des Eingangssignals ES mit dem Sägezahnsignal PS erfolgt, tritt am Ausgang der Sample and Hold-Schaltung 9 also ein treppenförmiges Signal auf, das über die Multiplexer 1 und 3 zu dem Analog/Digital-Wandler 4 gelangt. Abgesehen von dem Sonderfall, daß die maximale Amplitude des Sägezahnsignale PS gleich demjenigen Spannungsunterschied ist, der eine Änderung der Ausgangsdaten des Analog/Digital-Wandlers 4 um ein LSB bewirkt und außerdem die Mindest- oder Maximalamplitude des durch die Überlagerung des Eingangssignals ES mit dem Sägezahnsignal PS erhaltenen Signals exakt einem mittels des Analog/Digital-Wandlers 4 meßbaren Spannungswert entspricht, werden sich also die Ausgangsdaten des Analog/Digital-Wandlers 4 während des Verlaufes des Sägezahnsignals PS entlang seiner linearen Flanke S um wenigstens ein LSB ändern.

Auf die aus der Analog/Digital-Wandlung des Eingangssignals ES mit dem überlagerten Sägezahnsignal PS resultierenden Ausgangsdaten des Analog/Digital-Wandlers 4 wendet die elektronische Recheneinrichtung 6 eine dritte Übertragungsfunktion, die integrierend wirkt, in der Weise an, daß sie das Integral der Ausgangsdaten des Analog/Digital-Wandlers 4 für die bei der definierten Anzahl von Analog/Digital-Wandlungen zuletzt fortlaufend aufgetretenden Ausgangsdaten des Analog/Digital-Wandlers 4 bildet. Bei dieser Integration berücksichtigt die elektronische Recheneinrichtung 6 als Randbedingungen, die Maximalamplitude des Sägezahnsignals PS und die Lage des Sägezahnsignals PS relativ zu dem Eingangssignal ES nach der Überlagerung.

Als Resultat der Integration und damit als Resultat der Analog/Digital-Wandlung des Eingangssignals ES liefert die elektronische Recheneinrichtung 6 dann digitale Daten, deren bit-Anzahl größer als die bit-Anzahl des Analog/Digital-Wandlers ist. Dabei erhöht sich die bit-Anzahl entsprechend derjenigen Anzahl von Analog/Digital-Wandlungen, die während derjenigen Zeit vorgenommen werden, in der sich die Amplitude des Sägezahnsignals PS entlang seiner linearen Flanke um einen Wert ändert, der zu einer Änderung der Ausgangsdaten des Digital/Analog-Wandlers 4 um ein LSB führt. Ist wie im Falle des beschriebenen Ausführungsbeispieles die Maximalamplitude des Sägezahnsignals PS gleich einem LSB und werden während einer Periode des Sägezahnsignals PS 32 Analog/Digital-Wandlungen vorgenommen, erhöht sich also die bit-Anzahl der gemäß der zuletzt beschriebenen Betriebsart erhaltenen Ergebnisse der Analog/Digital-Wandlung von 14 auf 19 bit. Diese Betriebsart ist insbesondere dann von Interesse, wenn in der zuerst beschriebenen Betriebsart (Fig. 2 oder 3) bei der Wandlung des aufbereiteten Signals AS der Dynamikbereich des Analog/Digital-Wandlers 4 überschritten wird. Stellt die elektronische Recheneinrichtung 6 solche Überschreitungen fest, die beispielsweise daran erkannt werden können, daß sämtliche bits der Ausgangsdaten des Analog/Digital-Wandlers 4 den Wert logisch "1" besitzen, besteht die Möglichkeit auf die zuletzt beschriebene Betriebsweise überzugehen.

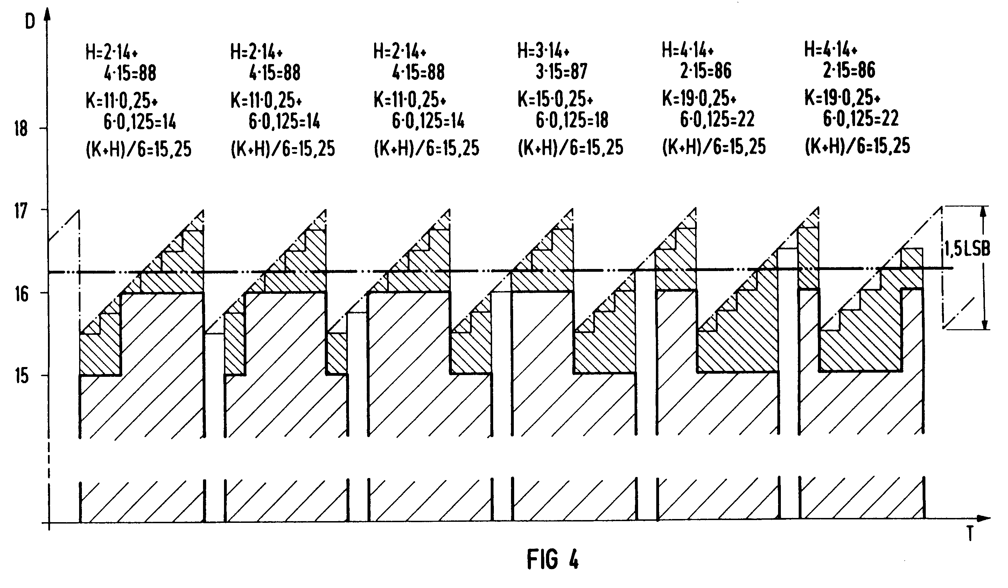

Die zuletzt beschriebene Betriebsweise der erfindungsgemäßen Einrichtung ist in Fig. 4 anhand eines Diagramms verdeutlicht, in dem einem konstanten Eingangssignal ES ein strichpunktiert eingetragenes Sägezahnsignal PS symmetrisch überlagert ist, dessen Amplitude 1,5 LSB beträgt. Während einer Periode des Sägezahnsignals PS werden sechs Analog/Digital-Wandlungen vorgenommen. Dies bedeutet, daß während derjenigen Zeit, in der sich die Amplitude des Sägezahnsignals PS um ein LSB ändert, vier Analog/Digital-Wandlungen vorgenommen werden. Wie dies anhand von sechs typischen Integrationsfeldern dargestellt ist, erfolgt die Integration jeweils über die Ausgangsdaten D von sechs aufeinanderfolgenden Analog/Digital-Wandlungen. Bei der Integration geht die elektronische Recheneinrichtung 6 derart vor, daß sie zunächst jeweils die Summe H von sechs aufeinanderfolgend angefallenen Ausgangsdaten des Digital/Analog-Wandlers 4 bildet. Die Summe F entspricht jeweils der in Fig. 4 von links nach rechts aufsteigend schraffierten Fläche. Außerdem ermittelt die elektronische Recheneinrichtung anhand der Anzahl K der höherwertigen Ausgangsdaten des Analog/Digital-Wandlers 4 jeweils die in Fig. 4 von links nach rechts abfallend schraffierten Flächen. Dies geschieht anhand eines den jeweiligen Gegebenheiten angepaßten, für den Fachmann leicht auffindbaren Algorithmus. Für jeden Integrationsvorgang addiert die elektronische Recheneinrichtung die Werte H und K und dividiert diese durch die Anzahl der während der Periodendauer vorgenommenen Analog/Digital-Wandlungen. Das Ergebnis der Division entspricht dem Resultat der Analog/Digital-Wandlung gemäß der zuletzt beschriebenen Betriebsweise und beträgt im Falle der Fig. 4 16,25.

Es ist leicht einzusehen, daß anstelle des im Falle des beschriebenen Ausführungsbeispieles verwendeten Sägezahnsignals PS auch ein beliebiges anderes Signal mit einer statistisch gleichmäßigen Amplitudenverteilung, z.B. ein Rauschsignal, dem Eingangssignal ES überlagert werden kann, um die beschriebene Erhöhung der bit-Anzahl der Analog/Digital-Wandlung zu erreichen.

In einer letzten Betriebsart, die zur Eichung bzw. zum Abgleich der erfindungsgemäßen Einrichtung dient, wird, indem die elektronische Recheneinrichtung den elektronischen Schalter 15 schließt (der elektronische Schalter 14 ist geöffnet), das Sägezahnsignal PS dem Summationspunkt 17 zugeführt. Das Sägezahnsignal PS wird also sowohl dem Eingangssignal ES als auch dem aufbereiteten Signal AS überlagert. Die elektronische Recheneinrichtung 6 ermittelt nun zum einen die Ergebnisse der Analog/Digital-Wandlung anhand des Eingangssignals ES in der im Zusammenhang mit Fig. 4 beschriebenen Weise. Zum anderen ermittelt die elektronische Recheneinrichtung parallel zu diesem Vorgang die Ergebnisse der Analog/Digital-Wandlung in der im Zusammemnhang mit Fig. 2 beschriebenen Betriebsart, wobei bezüglich der Offset-Spannung des Verstärkers 11 die im Zusammenhang mit Fig. 3 beschriebene Korrektur vorgenommen wird. Der Einrichtung wird nun ein beliebiges Signal zugeführt, das allerdings bezüglich des aufbereiteten Signals AS nicht zu Überschreitungen des Dynamikbereiches führen darf. Es besteht auch die Möglichkeit, den Eingang der Einrichtung kurzzuschließen, was bedeutet, daß das Eingangssignal ES den Wert Null besitzt. Die elektronische Recheneinrichtung vergleicht dann die gemäß Fig. 2 unter Heranziehung der dem aufbereiteten Signal AS entsprechenden digitalen Daten ermittelten Ergebnisse der Analog/Digital-Wandlung mit den gemäß Fig. 4 ohne Berücksichtigung der dem aufbereiteten Signal AS entsprechenden digitalen Daten allein unter Heranziehung der dem Eingangssignal ES entsprechenden, mit dem definierten Faktor F multiplizierten digitalen Daten ermittelten Ergebnisse der Analog/Digital-Wandlung in der Weise, daß sie deren Differenzen bildet. Im Idealfall geben die Differenzen den Verlauf des Sägezahnsignals PS wieder, da dieses im Falle der Ermittlung der Ergebnisse der Analog/Digital-Wandlung unter Heranziehung der dem aufbereiteten Signal AS entsprechenden digitalen Daten als Signalanteil aufgefaßt wird, im Falle der Analog/Digital-Wandlung des Eingangssignals ES jedoch nur als Hilfssignal verwendet wird. Falls die mittels der elektronischen Recheneinrichtung 6 gebildeten Differenzen wesentlich von dem Sägezahnsignal PS abweichen, kann ein Abgleich der erfindungsgemäßen Einrichtung erfolgen. Dies kann beispielsweise durch Anpassung der dritten Übertragungsfunktion T3 an die Bauteilwerte des Hochpasses 10, durch Korrektur des definierten Verstärkungsfaktors V, falls dieser einstellbar ist, oder durch Korrektur des definierten Faktors F geschehen.

## Patentansprüche

1. Verfahren zur Analog/Digital-Wandlung eines sich zeitlich ändernden analogen elektrischen Eingangssignals (ES) mit folgenden Verfahrensschritten:
a) zur Bildung eines aufbereiteten Signals (AS) wird auf das Eingangssignal (ES) eine erste Übertragungsfunktion (T1) angewendet und das Eingangssignal (ES) um einen definierten Verstärkungsfaktor (V) verstärkt,
b) zeitich aufeinanderfolgende samples sowohl des Eingangssignals (ES) als auch des aufbereiteten Signals (AS) werden jeweils einer Analog/Digital-Wandlung unterzogen, so daß dem Eingangssignal (ES) entsprechende digitale Daten einer bestimmten bit-Anzahl und dem aufbereiteten Signal (AS) entsprechende digitale Daten einer bestimmten bit-Anzahl erhalten werden, wobei die bit-Anzahl jeweils den Dynamikbereich der Analog/Digital-Wandlung bestimmt,
c) die dem Eingangssignal (ES) entsprechenden digitalen Daten werden jeweils mit einem definierten Faktor (F) multipliziert, der gleich dem definierten Verstärkungsfaktor (V) ist,
d) auf die dem Eingangssignal (ES) entsprechenden digitalen Daten wird durch digitales Filtern eine der ersten Übertragungsfunktion entsprechende zweite Übertragungsfunktion (T2) angewendet, und
e) die Ergebnisse der Analog/Digital-Wandlung werden unter Heranziehung sowohl der dem aufbereiteten Signal (AS) entsprechenden digitalen Daten als auch der unter Anwendung der zweiten Übertragungsfunktion (T2) digital gefilterten, dem Eingangssignal (ES) entsprechenden, mit dem definierten Faktor (F) multiplizierten, digitalen Daten ermittelt.

2. Verfahren nach Anspruch 1, **dadurch gekennzeichnet**, daß als erste Übertragungsfunktion (T1) die Übertragungsfunktion eines Hochpasses angewendet wird.

3. Verfahren nach Anspruch 1 oder 2, **dadurch gekennzeichnet**, daß die zweite Übertragungsfunktion (T2) das komplexe Komplement der ersten Übertragungsfunktion (T1) ist und daß die dem Eingangssignal (ES) entsprechenden digitalen Daten zur Ermittlung der Ergebnisse der Analog/Digital-Wandlung in der Weise herangezogen werden, daß die Summen der durch digitales Filtern des Eingangssignals (ES) erhaltenen digitalen Daten und der dem aufbereiteten Signal (AS) entsprechenden digitalen Daten gebildet werden.

4. Verfahren nach einem der Ansprüche 1 bis 3, **dadurch gekennzeichnet**, daß für zeitlich aufeinanderfolgende Samples die Differenz zwischen den dem Eingangssignal (ES) entsprechenden, mit dem definierten Faktor (F) multiplizierten digitalen Daten einerseits und den durch die Addition der dem aufbereiteten Signal (AS) entsprechenden digitalen Daten und der durch Anwendung der zweiten Übertragungsfunktion (T2) auf die dem Eingangssignal (ES) entsprechenden, mit dem definierten Faktor (F) multiplizierten digitalen Daten erhaltenen Summen andererseits gebildet wird und daß die so erhaltenen Differenzen zur Korrektur von Offset-Fehlern verwendet werden.

5. Verfahren nach Anspruch 4, **dadurch gekennzeichnet**, daß aus den für eine definierte Anzahl aufeinanderfolgender Samples ermittelten Differenzen unter Berücksichtigung von deren Vorzeichen der Mittelwert gebildet wird und daß der Mittelwert zur Korrektur von Offset-Fehlern verwendet wird.

6. Verfahren nach einem der Ansprüche 1 bis 5, **dadurch gekennzeichnet**, daß dem Eingangssignal (ES) vor der Analog/Digital-Wandlung ein sich zeitlich änderndes analoges elektrisches Signal (PS) überlagert wird, dessen Maximalamplitude wenigstens gleich demjenigen Spannungsunterschied ist, der einem least-significant-bit (LSB) bei der Analog/Digital-Wandlung des Eingangssignals (ES) entspricht, und das eine statistisch gleichmäßige Amplitudenverteilung aufweist, daß nach der Analog/Digital-Wandlung auf die dem aus der Überlagerung des Eingangssignals (ES) und des analogen Signals (PS) resultierenden Signal entsprechenden digitalen Daten durch digitales Filtern eine dritte Übertragungsfunktion angewendet wird, welche integrierend wirkt, und daß die so erhaltenen digitalen Daten bei Überschreitungen des Dynamikbereiches bei der Analog/Digital-Wandlung des aufbereiteten Signals (AS) als Ergebnisse der Analog/Digital-Wandlung ohne Berücksichtigung des aufbereiteten Signals (AS) verwendet werden.

7. Verfahren nach Anspruch 6, **dadurch gekennzeichnet**, daß als dritte Übertragungsfunktion die Übertragungsfunktion eines Tiefpasses angewendet wird.

8. Verfahren nach Anspruch 6 oder 7, **dadurch gekennzeichnet**, daß das analoge Signal (PS) ein periodisches Signal ist.

9. Einrichtung zur Analog/Digital-Wandlung eines sich zeitlich ändernden analogen elektrischen Eingangssignales (ES), umfassend Mittel (10, 11) zur Bildung eines aufbereiteten Signales (AS), welche auf das Eingangssignal (ES) eine erste Übertragungsfunktion (T1) anwenden und das Eingangssignal (ES) um einen definierten Verstärkungsfaktor (V) verstärken, Mittel (4, 9, 12) zur Analog/Digital-Wandlung, welche aufeinanderfolgende Samples sowohl des Eingangssignales (ES) als auch des aufbereiteten Signales (AS) jeweils einer Analog/Digital-Wandlung unterziehen, so daß dem Eingangssignal (ES) entsprechende digitale Daten einer bestimmten bit-Anzahl und dem aufbereiteten Signal (AS) entsprechende digitale Daten einer bestimmten bit-Anzahl als Ausgangsdaten der Mittel zur Analog/Digital-Wandlung vorliegen, wobei die bit-Anzahl jeweils den Dynamik-bereich der Mittel zur Analog/ Digital-Wandlung bestimmt, und eine mit den Mitteln (4, 9, 12) zur Analog/Digital-Wandlung zusammenwirkende elektronische Recheneinrichtung (6), welcher die Ausgangsdaten der Mittel (4, 9, 12) zur Analog/Digital-Wandlung zugeführt sind, wobei die elektronische Recheneinrichtung (6) derart ausgebildet ist,
a) daß sie die dem Eingangssignal (ES) entsprechenden digitalen Daten jeweils mit einem definierten Faktor (F) multipliziert, der gleich dem definierten Verstärkungsfaktor (V) ist,
b) daß sie auf die dem Eingangssignal (ES) entsprechenden digitalen Daten durch digitales Filtern eine der ersten Übertragungsfunktion entsprechende zweite Übertragungsfunktion (T2) angewendet, und
c) daß sie die Ergebnisse der Analog/Digital-Wandlung unter Heranziehung sowohl der dem aufbereiteten Signal (AS) entsprechenden digitalen Daten ermittelt als auch der unter Anwendung der zweiten Übertragungsfunktion (T2) digital gefilterten dem Eingangssignal (ES) entsprechenden, mit dem definierten Faktor (F) multiplizierten digitalen Daten ermittelt.

10. Einrichtung nach Anspruch 9, **dadurch gekennzeichnet**, daß die Mittel (10, 11) zur Bildung des aufbereiteten Signales (AS) als erste Übertragungsfunktion (T1) die Übertragungsfunktion eines Hochpasses auf das Eingangssignal (ES) anwenden.

11. Einrichtung nach Anspruch 9 oder 10, **dadurch gekennzeichnet**, daß die elektronische Recheneinrichtung (6) derart ausgebildet ist, daß sie auf die dem Eingangssignal (ES) entsprechenden, digitalen Daten als zweite Übertragungsfunktion (T2) das komplexe Komplement der ersten Übertragungsfunktion (T1) anwendet und daß sie die dem Eingangssignal (ES) entsprechenden digitalen Daten zur Ermittlung der Ergebnisse der Analog/Digital-Wandlung in der Weise heranzieht, daß sie die Summen der durch digitales Filtern des Eingangssignales (ES) erhaltenen digitalen Daten und der dem aufbereiteten Signal (AS) entsprechenden digitalen Daten bildet.

12. Einrichtung nach einem der Ansprüche 9 bis 11, **dadurch gekennzeichnet**, daß die elektronische Recheneinrichtung (6) derart ausgebildet ist, daß sie für zeitlich aufeinanderfolgende Samples die Differenz zwischen den dem Eingangssignal (ES) entsprechenden, mit dem definierten Faktor (F) multiplizierten digitalen Daten einerseits und den durch die Addition der dem aufbereiteten Signal (AS) entsprechenden digitalen Daten und der durch Anwendung der zweiten Übertragungsfunktion (T2) auf die dem Eingangssignal (ES) entsprechenden, mit dem definierten Faktor (F) multiplizierten digitalen Daten erhaltenen Summen andererseits bildet und die so erhaltenen Differenzen zur Korrektur von Offset-Fehlern verwendet.

13. Einrichtung nach Anspruch 12, **dadurch gekennzeichnet**, daß die elektronische Recheneinrichtung (6) derart ausgebildet ist, daß sie aus den für eine definierte Anzahl aufeinanderfolgender Samples ermittelten Differenzen unter Berücksichtigung von deren Vorzeichen den Mittelwert bildet und diesen zur Korrektur von Offset-Fehlern verwendet.

14. Einrichtung nach einem der Ansprüche 9 bis 13, **dadurch gekennzeichnet**, daß Mittel (13) zur Erzeugung eines analogen Signales (PS) vorgesehen sind, die ein analoges Signal (PS) erzeugen, dessen Maximalamplitude wenigstens gleich demjenigen Spannungsunterschied ist, der einem least significant bit (LSB) bei der Analog /Digital-Wandlung des Eingangssignales (ES) entspricht, und das eine statistisch gleichmäßige Amplitudenverteilung aufweist, daß Mittel (14, 15, 16, 17) zur Überlagerung des periodischen Signales (PS) mit dem Eingangssignal (ES) vorgesehen sind, und daß die elektronische Recheneinrichtung (6) derart ausgebildet ist, daß sie auf die dem aus der Überlagerung des Eingangssignales (ES) und des analogen Signales (PS) resultierenden Signal entsprechenden Ausgangsdaten der Mittel (4, 9, 12) zur Analog-Digital-Wandlung durch digitales Filtern eine dritte Übertragungsfunktion anwendet, welche integrierend wirkt, und daß sie die so erhaltenen digitalen Daten bei Überschreitungen des Dynamikbereiches bei der Analog/Digital-Wandlung des aufbereiteten Signals (AS) als Ergebnisse der Analog/Digital-Wandlung ohne Berücksichtigung des aufbereiteten Signals (AS) verwendet.

15. Einrichtung nach Anspruch 14, **dadurch gekennzeichnet**, daß die elektronische Recheneinrichtung (6) derart ausgebildet ist, daß sie als dritte Übertragungsfunktion auf die dem resultierenden Signal entsprechenden digitalen Daten die Übertragungsfunktion eines Tiefpasses anwendet.

16. Einrichtung nach Anspruch 14 oder 15, **dadurch gekennzeichnet**, daß die Mittel (13) zur Erzeugung eines analogen Signales (PS) ein periodisches Signal erzeugen.

17. Verfahren zur Eichung einer Einrichtung nach einem der Ansprüche 9 bis 16, **dadurch gekennzeichnet**,
a) daß dem Eingangssignal (ES) vor der Bildung des aufbereiteten Signals (AS) ein sich zeitlich änderndes analoges elektrisches Signal (PS) überlagert wird, dessen Maximalamplitude wenigstens gleich demjenigen Spannungsunterschied ist, der einem Least-Significant-Bit (LSB) bei der Analog/Digital-Wandlung des Eingangssignals (ES) entspricht, und das eine statistisch gleichmäßige Amplitudenverteilung aufweist,
b) daß die Ergebnisse der Analog/Digital-Wandlung unter Heranziehung sowohl der dem aufbereiteten Signal (AS) entsprechenden digitalen Daten als auch der unter Anwendung der zweiten Übertragungsfunktion (T2) digital gefilterten dem Eingangssignal (ES) entsprechenden, mit dem definierten Faktor (F) multiplizierten, digitalen Daten ermittelt werden,
c) daß das aus der Überlagerung des Eingangssignals (ES) und des analogen Signals (BS) resultierende Signal einer Analog/Digital-Wandlung unterzogen wird und auf die so erhaltenen, mit dem definierten Faktor (F) multiplizierten digitalen Daten durch digitales Filtern eine integrierend wirkende Übertragungsfunktion angewendet wird, und
d) daß für die einzelnen Samples ein Vergleich der Ergebnisse der Analog/Digital-Wandlung mit den unter Anwendung der integrierend wirkenden Übertragungsfunktion und Multiplikation mit dem definierten Faktor (F) aus der Analog/Digital-Wandlung des aus der Überlagerung des Eingangssignals (ES) und des analogen Signals (PS) erhaltenen digitalen Daten vorgenommen wird.

18. Verfahren nach Anspruch 17, **dadurch gekennzeichnet**, daß die Ergebnisse des Vergleiches zur Fehlerkorrektur verwendet werden.

19. Verfahren nach Anspruch 17 oder 18 zur Eichung einer Einrichtung nach einem der Ansprüche 14 bis 16, **dadurch gekennzeichnet**, daß das mittels der Mittel (13) zur Erzeugung eines analogen Signales (PS) erzeugte Signal dem Eingangssignal (ES) überlagert wird.

20. Verfahren nach einem der Ansprüche 17 bis 19, **dadurch gekennzeichnet**, daß während des Eichvorganges das Eingangssignal (ES) den Wert Null besitzt.

## Claims

1. A process for the analogue/digital conversion of a time-variable, analogue, electrical input signal (ES) comprising the following process steps:
a) for the formation of a conditioned signal (AS), a first transmission function (T1) is applied to the input signal (ES) and the input signal (ES) is amplified by a defined amplification factor (V),
b) sequential samples both of the input signal (ES) and of the conditioned signal (AS) are in each case subjected to analogue-digital conversion so that digital data items which correspond to the input signal (ES) and which possess a specified number of bits and digital data items which correspond to the conditioned signal (AS) and which possess a specified number of bits are obtained, where the number of bits in each case determines the dynamic range of the analogue/digital conversion,
c) the digital data items corresponding to the input signal (ES) are in each case multiplied by a defined factor (F) which is equal to the defined amplification factor (V),
d) a second transmission function (T2) corresponding to the first transmission function is applied by digital filtering to the digital data items corresponding to the input signal (ES) and
e) the results of the analogue/digital conversion are determined using both the digital data items corresponding to the conditioned signal (AS) and the digital data items which have been digitally filtered with the application of the second transmission function (T2), correspond to the input signal (ES) and have been multiplied by the defined factor (F).

2. A process according to Claim 1, characterised in that the transmission function of a high-pass filter is applied as first transmission function (T1).

3. A process according to Claim 1 or 2, characterised in that the second transmission function (T2) is the complex complement of the first transmission function (T1) and that the digital data items corresponding to the input signal (ES) are used to determine the results of the analogue/digital conversion in that the sums are formed of the digital data items obtained by digital filtering of the input signal (ES) and the digital items corresponding to the conditioned signal (AS).

4. A process according to one of Claims 1 to 3, characterised in that for sequential samples, the difference is formed between on the one hand the digital data items which correspond to the input signal (ES) and have been multiplied by the defined factor (F) and on the other hand the sums obtained by the addition of the digital data items corresponding to the conditioned signal (AS) and the digital data items which correspond by the application of the second transmission function (T2) to the input signal (ES) and have been multiplied by the defined factor (F), and that the differences thus obtained are used to correct offset errors.

5. A process according to Claim 4, characterised in that the mean value is formed of the differences determined for a defined number of sequential samples taking into consideration the signs thereof, and that the mean value is used to correct offset errors.

6. A process according to one of Claims 1 to 5, characterised in that prior to the analogue/digital conversion a time-variable analogue, electrical signal (PS) is superimposed upon the input signal (ES), where the maximum amplitude of said signal (PS) is at least equal to that voltage difference corresponding to one least-significant-bit (LSB) in the analogue/digital conversion of the input signal (ES) and which signal (PS) possesses a statistically uniform amplitude distribution, that after the analogue/digital conversion a third transmission function is applied by digital filtering to the digital data items corresponding to the signal resulting from the superimposition of the input signal (ES) and the analogue signal (PS), which third transmission function has an integrating action, and that in the case of the overshooting of the dynamic range in the analogue/digital conversion of the conditioned signal (AS) the digital data items thus obtained are used as results of the analogue/digital conversion without taking into consideration the conditioned signal (AS).

7. A process according to Claim 6, characterised in that the transmission function of a low-pass filter is used as third transmission function.

8. A process according to Claim 6 or 7, characterised in that the analogue signal (PS) is a periodic signal.

9. A device for the analogue/digital conversion of a time-variable, analogue electrical input signal (ES) comprising means (10, 11) for the formation of a conditioned signal (AS), which means apply a first transmission function (T1) to the input signal (ES) and amplify the input signal (ES) by a defined amplification factor (V), further comprising means (4, 9, 12) for analogue/digital conversion which subject sequential samples both of the input signal (ES) and of the conditioned signal (AS) in each case to analogue/digital conversion, so that digital data items which correspond to the input signal (ES) and which possess a specified number of bits and digital data items which correspond to the conditioned signal (AS) and which possess a specified number of bits are available as output data of the analogue/digital conversion means, where the number of bits in each case determines the dynamic range of the analogue/digital conversion means, and further comprising an electronic calculating device (6) which cooperates with the means (4, 9, 12) for the analogue/digital conversion and which is supplied with the output data of the means (4, 9, 12) for the analogue-digital conversion, where the electronic calculating device (6) is designed such
a) that it in each case multiplies the digital data items corresponding to the input signal (ES) by a defined factor (F) which is equal to the defined amplification factor (V),
b) that it applies a second transmission function (T2) corresponding to the first transmission function by digital filtering to the digital data items corresponding to the input signal (ES) and
c) that it determines the results of the analogue/digital conversion using both the digital data items corresponding to the conditioned signal (AS) and the digital data items which have been digitally filtered using the second transmission function (T2), correspond to the input signal (ES) and have been multiplied by the defined factor (F).

10. A device according to Claim 9, characterised in that the means (10, 11) for the formation of the conditioned signal (AS) apply the transmission function of a high-pass filter as first transmission function (T1) to the input signal (ES).

11. A device according to Claim 9 or 10, characterised in that the electronic calculating device (6) is designed such that it applies the complex complement of the first transmission function (T1) as second transmission function (T2) to the digital data items corresponding to the input signal (ES) and that it uses the digital data items corresponding to the input signal (ES) to determine the results of the analogue/digital conversion in that it forms the sums of the digital data items obtained by digital filtering of the input signal (ES) and the digital items corresponding to the conditioned signal (AS).

12. A device according to one of Claims 9 to 11, characterised in that the electronic calculating device (6) is designed such that for sequential samples it forms the difference between on the one hand the digital data items which correspond to the input signal (ES) and have been multiplied by the defined factor (F) and on the other hand the sums obtained by the addition of the digital data items corresponding to the conditioned signal (AS) and the digital data items which correspond by the application of the second transmission function (T2) to the input signal (ES) and have been multiplied by the defined factor (F) and uses the differences thus obtained to correct offset errors.

13. A device according to Claim 12, characterised in that the electronic calculating device (6) is designed such that it forms the mean value of the differences determined for a defined number of sequential samples taking into consideration the signs thereof and uses said mean value to correct offset errors.

14. A device according to one of Claims 9 to 13, characterised in that means (13) for the generation of an analogue signal (PS) are provided, which means generate an analogue signal (PS), the maximum amplitude of which is at least equal to the voltage difference corresponding to one least significant bit (LSB) in the analogue/digital conversion of the input signal (ES) and which possesses a statistically uniform amplitude distribution, that means (14, 15, 16, 17) for the superimposition of the periodic signal (PS) with the input signal (ES) are provided, and that the electronic calculating device (6) is designed such that it applies, by digital filtering, a third transmission function to the output data of the analogue digital conversion means (4, 9, 12), which output data correspond to the signal resulting from the superimposition of the input signal (ES) and the analogue signal (PS), where said third transmission function has an integrating action, and that in the event of the overshooting of the dynamic range in the analogue/digital conversion of the conditioned signal (AS) the said calculating device (6) uses the digital data items thus obtained as results of the analogue/digital conversion without taking into consideration the conditioned signal (AS).

15. A device according to Claim 14, characterised in that the electronic calculating device (6) is designed such that it applies the transmission function of a low-pass filter as third transmission function to the digital data items corresponding to the resultant signal.

16. A device according to Claim 14 or 15, characterised in that the means (13) for the generation of an analogue signal (PS) generate a periodic signal.

17. A process for the calibration of a device according to one of Claims 9 to 16, characterised in that
a) a time-variable, analogue, electrical signal (PS) is superimposed upon the input signal (ES) prior to the formation of the conditioned signal (AS), where the maximum amplitude of said signal (PS) is at least equal to that voltage difference corresponding to one least significant bit (LSB) in the analogue/digital conversion of the input signal (ES) and which signal (PS) possesses a statistically uniform amplitude distribution,
b) the results of the analogue/digital conversion are determined using both the digital data items corresponding to the conditioned signal (AS) and the digital data items which have been digitally filtered by the application of the second transmission function (T2), correspond to the input signal (ES) and have been multiplied by the defined factor (F),
c) the signal resulting from the superimposition of the input signal (ES) and the analogue signal (BS) is subjected to analogue/digital conversion and an integrating transmission function is applied by digital filtering to the thus obtained digital data items multiplied by the defined factor (F), and
d) for the individual samples a comparison is carried out between the results of the analogue/digital conversion and the digital data items obtained, by means of application of the integrating transmission function and multiplication by the defined factor (F), from the analogue/digital conversion of the signal resulting from) the superimposition of the input signal (ES) and the analogue signal (PS).

18. A process according to Claim 17, characterised in that the results of the comparison are used for the error correction.

19. A process according to Claim 17 or 18 for the calibration of a device according to one of Claims 14 to 16, characterised in that the signal generated by the means (13) for the generation of an analogue signal (PS) is superimposed upon the input signal (ES).

20. A process according to one of Claims 17 to 19, characterised in that during the calibration process the input signal (ES) possesses the value zero.

## Revendications

1. Procédé de conversion analogique/numérique d'un signal électrique d'entrée analogique (ES) qui varie dans le temps, mettant en oeuvre les étapes suivantes :
a) pour la formation d'un signal élaboré (AS), on applique au signal d'entrée (ES) une première fonction de transfert (T1) et on amplifie le signal électrique (ES) d'un facteur d'amplification déterminé (V),
b) on soumet des échantillons, successifs dans le temps, aussi bien du signal d'entrée (ES) que du signal élaboré (AS) respectivement à une conversion analogique/numérique de manière à obtenir des données numériques qui correspondent au signal d'entrée (ES) et qui possèdent un nombre de bits déterminé, et des données numériques, qui correspondent au signal élaboré (AS) et qui possèdent un nombre de bits déterminé, le nombre de bits déterminant respectivement la gamme dynamique de la conversion analogique/numérique,
c) les données numériques, qui correspondent au signal d'entrée (ES), sont multipliées respectivement par un facteur défini (F), qui est égal au facteur d'amplification défini (V),
d) au moyen d'un filtrage numérique, on applique une seconde fonction de transfert (T2), qui correspond à la première fonction de transfert, aux données numériques qui correspondent au signal d'entrée (ES), et
e) on détermine les résultats de la conversion analogique/ numérique en utilisant aussi bien les données numériques, qui correspondent au signal élaboré (AS) que les données numériques filtrées d'une manière numérique moyennant l'utilisation de la seconde fonction de transfert (T2) et qui correspondent au signal d'entrée (ES) et sont multipliées par le facteur défini (F).

2. Procédé suivant la revendication 1, caractérisé par le fait qu'on utilise comme première fonction de transfert (T1) la fonction de transfert d'un filtre passe-haut.

3. Procédé suivant la revendication 1 ou 2, caractérisé par le fait que la seconde fonction de transfert (T2) est le complément complexe de la première fonction de transfert (T1), et qu'on utilise des données numériques qui correspondent au signal d'entrée (ES), pour la détermination des résultats de la conversion analogique/numérique en formant les sommes des données numériques qui sont obtenues par filtrage numérique du signal d'entrée (ES), et des données numériques qui correspondent au signal élaboré (AS).

4. Procédé suivant l'une des revendications 1 à 3, caractérisé par le fait que pour des échantillons successifs dans le temps, on forme la différence entre, d'une part, les données numériques, qui correspondent au signal d'entrée (ES) et qui sont multipliées par le facteur numérique (F), et d'autre part, les sommes obtenues par l'addition, des données numériques qui correspondent au signal élaboré (AS) et des données numériques qui correspondent par application de la seconde fonction de transfert (T2) au signal d'entrée (ES) et qui sont multipliées par le facteur défini (F), et qu'on utilise les différences ainsi obtenues pour corriger des erreurs d'offset.

5. Procédé suivant la revendication 4, caractérisé par le fait qu'on forme la valeur moyenne à partir des différences déterminées pour le nombre défini d'échantillons successifs, en tenant compte de leurs signes et qu'on utilise la valeur moyenne pour corriger des erreurs d'offset.

6. Procédé suivant l'une des revendications 1 à 5, caractérisé par le fait qu'au signal d'entrée (ES) on superpose, avant la conversion analogique/numérique, un signal électrique analogique (PS), qui varie dans le temps et dont l'amplitude maximale est au moins égale à la différence de tension qui correspond à un bit de poids minimum (LSB) lors de la conversion analogique/numérique du signal d'entrée (ES), et qui possède une distribution d'amplitude uniforme du point de vue statistique, qu'après la conversion analogique/ numérique on applique, par filtrage numérique, une troisième fonction de transfert, qui agit par intégration, sur les données numériques qui correspondent au signal obtenu par superposition du signal d'entrée (ES) et du signal analogique (PS), et que lors du dépassement de la gamme dynamique, lors de la conversion analogique/numérique du signal élaboré (AS), on utilise les données numériques ainsi obtenues en tant que résultats de la conversion analogique/numérique sans tenir, compte du signal élaboré (AS).

7. Procédé suivant la revendication 6, caractérisé par le fait qu'on utilise comme troisième fonction de transfert la fonction de transfert d'un filtre passe-bas.

8. Procédé suivant la revendication 6 ou 7, caractérisé par le fait que le signal analogique (PS) est un signal périodique.

9. Dispositif de conversion analogique/numérique d'un signal électrique d'entrée analogique (ES) qui varie dans le temps, comprenant des moyens (10,11) pour former un signal élaboré (AS), qui appliquent une première fonction de transfert (T1) au signal d'entrée (ES) et amplifient le signal d'entrée (ES) avec un facteur d'amplification indéfini (V), des moyens (4,9,12) pour réaliser la conversion analogique/numérique et qui soumettent des échantillons successifs aussi bien du signal d'entrée (ES) que du signal élaboré (AS) respectivement à une conversion analogique/ numérique de manière à obtenir des données numériques qui correspondent au signal d'entrée (ES) et possèdent un nombre de bits déterminé et des données numériques qui correspondent au signal élaboré (AS) et qui possèdent un nombre de bits déterminés, en tant que données de sortie des moyens de conversion analogique/numérique, le nombre de bits déterminant respectivement la gamme dynamique des moyens de conversion analogique/numérique, et un dispositif de calcul électronique (6), qui coopère avec les moyens de conversion analogique/numérique (4,9,12) et auquel sont envoyées les données de sortie des moyens de conversion analogique/ numérique (4,9,12), le dispositif de calcul électronique (6) étant agencé de telle sorte
a) qu'il multiplie les données numériques, qui correspondent au signal d'entrée (ES), respectivement par un facteur défini (F) qui est égal au facteur d'amplification défini (V),
b) qu'il applique aux données numériques correspondant au signal d'entrée (ES), par filtrage numérique, une fonction de transfert (T2) qui correspond à la première fonction de transfert, et
c) qu'il détermine les résultats de la conversion analogique/numérique en utilisant aussi bien les données numériques, qui correspondent au signal élaboré (AS), que les données numériques, qui sont filtrées numériquement moyennant l'utilisation de la seconde fonction de transfert (T2), correspondent au signal d'entrée (ES) et multipliées par le facteur défini (F).

10. Dispositif suivant la revendication 9, caractérisé par le fait que les moyens (10,11) de formation du signal élaboré (AS) appliquent, comme première fonction de transfert (T1), la fonction de transfert d'un filtre passe-haut au signal d'entrée (ES).

11. Dispositif suivant la revendication 9 ou 10, caractérisé par le fait que le dispositif de calcul électronique (6) est agencé de telle sorte qu'il applique, comme seconde fonction de transfert (T2), le complément complexe de la première fonction de transfert (T1) aux données numériques qui correspondent au signal d'entrée (ES), et qu'il utilise les données numériques, qui correspondent au signal d'entrée (ES), pour déterminer les résultats de la comparaison analogique/numérique de manière à former les sommes des données numériques, qui sont obtenues par filtrage numérique du signal d'entrée (ES), et des données numériques, qui correspondent au signal élaboré (AS).

12. Dispositif suivant l'une des revendications 9 à 11, caractérisé par le fait que le dispositif de calcul électronique (6) est agencé de telle sorte que pour des échantillons successifs dans le temps, il utilise la différence entre, d'une part, les données numériques qui correspondent au signal d'entrée (ES) et qui sont multipliées par le facteur numérique (F), et d'autre part, les sommes obtenues par l'addition, des données numériques, qui correspondent au signal élaboré (AS) et des données numériques qui correspondent, par application de la seconde fonction de transfert (T2), au signal d'entrée (ES) et sont multipliées par le facteur défini (F), et qu'on utilise les différences ainsi obtenues pour corriger des erreurs d'offset.

13. Dispositif suivant la revendication 12, caractérisé par le fait que le dispositif de calcul électronique (6) est agencé de telle sorte qu'il utilise la valeur moyenne à partir des différences déterminées pour le nombre défini d'échantillons successifs, en tenant compte de leurs signes et qu'on utilise la valeur moyenne pour corriger les erreurs d'offset.

14. Dispositif suivant l'une des revendications 9 à 13, caractérisé par le fait qu'il est prévu des moyens (13) pour produire un signal analogique (PS), qui produisent un signal analogique (PS), dont l'amplitude maximale est au moins égale à la différence de tension qui correspond à un bit de poids plus faible (LSB) lors de la conversion analogique/numérique du signal d'entrée (ES), et qui possède une distribution d'amplitude uniforme du point de vue statistique, que des moyens (14,15,16,17) sont prévus pour superposer le signal d'entrée (ES) au signal périodique (PS), et que le dispositif de calcul électronique (6) est agencé de telle sorte qu'il applique, par filtrage numérique, une troisième fonction de transfert, qui agit par intégration, aux données de sortie des moyens de conversion analogique/ numérique (4,9,12), qui correspondent au signal qui résulte de la superposition du signal d'entrée (ES) et du signal analogique (PS), et qu'il utilise les données numériques ainsi obtenues lors du dépassement de la gamme dynamique, lors de la conversion analogique/numérique du signal élaboré (AS), en tant que résultats de la conversion analogique/ numérique, sans tenir compte du signal préparé (AS).

15. Dispositif suivant la revendication 14, caractérisé par le fait que l'unité de calcul électronique (6) est agencée de telle sorte qu'il applique comme troisième fonction de transfert la fonction de transfert d'un filtre passe-bas aux données numériques qui correspondent au signal résultant.

16. Dispositif suivant la revendication 14 ou 15, caractérisé par le fait que les moyens (13) de production d'un signal analogique (PS) produisent un signal périodique.

17. Procédé pour étalonner un dispositif suivant l'une des revendications 9 à 16, caractérisé par le fait
a) qu'avant la formation du signal élaboré (AS), on superpose au signal d'entrée (ES) un signal électrique analogue (PS) qui varie dans le temps et dont l'amplitude maximale est au moins égale à la différence de tension qui correspond à un bit de poids minimum (LSB) lors de la conversion analogique/numérique du signal d'entrée (ES) et qui possède une distribution d'amplitude uniforme du point de vue statistique,
b) qu'on détermine les résultats de la conversion analogique/numérique en utilisant aussi bien les données numériques qui correspondent au signal élaboré (AS), que les données numériques qui sont filtrées numériquement par application de la seconde fonction de transfert (T2), qui correspondent au signal d'entrée (ES) et qui sont multipliées par le facteur défini (F),
c) qu'on soumet à une conversion numérique/analogique le signal obtenu par superposition du signal d'entrée (ES) et du signal analogique (PS), et qu'on applique, par filtrage numérique, une fonction de transfert agissant par intégration, aux données numériques ainsi obtenues, multipliées par le facteur défini (F), et
d) que pour les échantillons individuels, on effectue une comparaison des résultats de la conversion analogique/ numérique aux données numériques, qui sont obtenues moyennant l'application de la fonction de transfert agissant par intégration et la multiplication avec le facteur défini (F), à partir de la conversion analogique/numérique du signal obtenu par la superposition du signal d'entrée (ES) et du signal analogique (PS).

18. Procédé suivant la revendication 17, caractérisé par le fait que les résultats de la comparaison sont utilisés pour la correction d'erreurs.

19. Procédé suivant la revendication 17 ou 18 pour l'étalonnage d'un dispositif suivant l'une des revendications 14 à 16, caractérisé par le fait qu'on superpose le signal fourni par les moyens (13) de production d'un signal analogique (PS) au signal d'entrée (ES).

20. Procédé suivant l'une des revendications 17 à 19, caractérisé par le fait que pendant l'opération d'étalonnage, le signal d'entrée (ES) possède la valeur zéro.
